Europäisches Patentamt

European Patent Office

Office européen des brevets

(19)

(11) **EP 0 791 667 A2**

## (12) EUROPÄISCHE PATENTANMELDUNG

(43) Veröffentlichungstag:
27.08.1997 Patentblatt 1997/35

(51) Int. Cl.⁶: $C23C\ 14/50$, $B65G\ 47/90$

(21) Anmeldenummer: 96115645.2

(22) Anmeldetag: 30.09.1996

(84) Benannte Vertragsstaaten:
CH DE FR GB LI NL SE

(30) Priorität: 23.02.1996 DE 19606764

(71) Anmelder: Singulus Technologies GmbH
63755 Alzenau (DE)

(72) Erfinder: Kempf, Stefan
63755 Alzenau-Albstadt (DE)

(74) Vertreter: VOSSIUS & PARTNER
Siebertstrasse 4
81675 München (DE)

(54) **Vorrichtung zum Greifen, Halten und/oder Transportieren von Substraten**

(57) **Die Erfindung bezieht sich auf** eine Vorrichtung 1 zum Greifen, Halten und/oder Transportieren von Substraten 2, zu der eine Eingangsstation 3 und mehrere in Reihe oder kreisförmig angeordnete Prozeßstationen 4 bis 9 zur Aufnahme des Substrats 2 gehören, zu denen das Substrat 2 über eine an Greiferarmen 13 angeordnete, Greiferelemente 24 aufweisende Transportvorrichtung 1 bzw. einen Drehtisch 12 weitergeleitet und dann an eine oder mehrere Ablagestationen 14 abgegeben wird, wobei mehrere Greiferarme 13 mittels des Drehtisches 12 in horizontaler und/oder vertikaler Richtung verstellbar sind. Einige Greiferelemente 24 sind mittels des Drehtisches 12 gemeinsam in horizontaler und/oder vertikaler Richtung und zumindest ein Greiferarm 13' unabhängig von den übrigen Greiferarmen 13 in mindestens eine der Bewegungsrichtungen verstellbar.

Fig. 1

## Beschreibung

**Die Erfindung bezieht sich auf** eine Vorrichtung zum Greifen, Halten und/oder Transportieren von Substraten, zu der eine Ausgangsstation und mehrere in Reihe oder kreisförmig angeordnete Prozeßstationen zur Aufnahme des Substrats gehören, zu denen das Substrat über eine an Greiferarmen angeordnete, Greiferelemente aufweisende Transportvorrichtung bzw. Drehtisch weitergeleitet und dann an eine oder mehrere Ablagestationen abgegeben wird, wobei mehrere Greiferarme mittels des Drehtisches in horizontaler und/oder vertikaler Richtung verstellbar sind.

**Es ist bereits eine** Vorrichtung zum Greifen und Halten bzw. zum Transportieren von Substraten bekannt, zu der eine Ausgangsstation gehört, über die das Substrat in die Anlage eingebracht wird. An diese Ausgangsstation schließen sich mehrere in Reihe oder kreisförmig angeordnete Prozeßstationen an, die über das Substrat aufnehmende Greiferarme angefahren werden. Zwischen den einzelnen Positionen müssen die Greiferarme jeweils angehoben werden, um von einer Position zur anderen Position gebracht zu werden. Eine derartige Verstellung erfolgte bisher über einzelne pneumatische Zylinder, eine Anordnung, die sehr aufwendig und teuer ist, da jeder einzelne Greiferarm getrennt angesteuert werden muß, insbesondere weil zur Beschickung der Schleuse der Greiferarm unabhängig von den übrigen Greiferarmen verstellt wird, um zu erreichen, daß beim Einschleusen der notwendige Vakuumdruck für eine bestimmte Zeit in der Schleuse aufrecht erhalten wird.

**Demgegenüber liegt der Erfindung die Aufgabe zugrunde,** die Antriebsvorrichtung für die einzelnen Greiferarme kostengünstiger auszubilden und die Ansteuerung der einzelnen Greiferarme zu vereinfachen.

**Gelöst wird die Aufgabe erfindungsgemäß dadurch,** daß einige Greiferelemente mittels des Drehtisches gemeinsam in horizontaler und/oder vertikaler Richtung und zumindest ein Greiferarm unabhängig von den übrigen Greiferarmen in mindestens eine der Bewegungsrichtungen verstellbar sind. Durch die vorteilhafte Ausbildung und Anordnung der einzelnen Greiferelemente ist es erstmals möglich, fast sämtliche Greiferelemente bis auf das eine, der Kathode zugeordnete Greiferelement zu verstellen, so daß auf die bisher übliche Einzelverstellung der Greiferarme verzichtet werden kann. Dies wird insbesondere dadurch erreicht, daß der der Kathode zugeordnete Greiferarm von der Hubvorrichtung der übrigen Greiferarme einzeln verstellbar ist. Wird also in der ersten Stellung bzw. Übergabeposition des Substrats zwischen Greiferelement und Schleuse der Beschichtungsanlage das Substrat in die Schleuse eingegeben, so kann der am Greiferarm angeordnete Deckel vakuumdicht auf die Schleusenkammer aufgesetzt werden und durch die Entkopplung des Tellers vom Greiferarm dieser nunmehr nach oben verstellt werden, wobei der in der Schleuse auftretende Differenzdruck $P_d = P_a - P_v$ den Teller auf der Schleuse hält. Durch den Anhubvorgang werden die fest mit den Greiferarmen verbundenen Teller und Greiferelemente nach Loslassen der Substrate an den einzelnen Arbeitspositionen nach oben verstellt, so daß die Substrate aus dieser entsprechenden Stellung in ihre jeweilige Arbeitsstellung verstellt werden können. Bei diesem Arbeitsvorgang wird der Substrataustausch in der Erstposition zwischen dem Aufnahmeteil und dem Greiferelement des ersten Greiferarms nicht beeinträchtigt. Wenn die Schleuse geflutet wird, kann der Teller an einer entsprechenden Vorrichtung am Greiferelement wieder nach oben bewegt werden, so daß der Greiferarm wieder in seine Ausgangs- oder Eingangsposition zurückverstellt werden kann.

Hierzu ist es vorteilhaft, daß das eine bzw. erste Greiferelement zumindest in eine vertikale Bewegungsrichtung unabhängig von den übrigen Greiferarmen bzw. Greiferelementen verstellbar ist.

Vorteilhaft ist es auch, daß ein Greiferelement zumindest in eine horizontale Bewegungsrichtung unabhängig von den anderen Greiferelementen und/oder Greiferarmen verstellbar ist, deren Bewegungsebene oder Bewegungsrichtung in etwa parallel zur Bewegungsebene oder Oberfläche des Drehtisches oder der Standfläche der Vorrichtung verläuft oder die Drehachse des Drehtisches in einem annähernd rechten Winkel schneidet.

Vorteilhaft ist es ferner, daß das eine bzw. erste Greiferelement zumindest in Richtung der Hubbewegung des Greiferarms unabhängig von der Hubbewegung des Greiferarms verstellbar ist und bei einer Hubbewegung des Greiferarms das Greiferelement mit dem zugehörigen Deckel über einen sich in einer Schleusenkammer aufbauenden Differenzdruck $P_d$ auf dem im Substrathalter liegenden Kammer- oder Rezipientendeckel gehalten und das vom Drehteller aufgenommene Substrat an eine Kathode weitergeleitet wird. Durch die Entkopplung des Greiferelements und des zugehörigen Deckels am ersten Greiferarm läßt dieser gemeinsam mit den anderen Greiferarmen über den Drehtisch eine Hubbewegung zu, ohne daß dadurch die Schleusenkammer geflutet wird, da der erste Teller auf der Schleusenkammeröffnung aufsitzen bleibt. Hierdurch können Antriebselemente, insbesondere Hydraulikzylinder zur Verstellung der einzelnen Greiferarme eingespart werden.

Gemäß einer bevorzugten Ausführungsform der erfindungsgemäßen Lösung ist schließlich vorgesehen, daß der Substrathalter bzw. Deckel in einer Richtung über den Differenzdruck $P_a$ und in der anderen Richtung über die Stellkraft eines Druckmittels bzw. einer Feder verstellbar und die anderen Substrathalter bzw. Deckel in mindestens einer Richtung über einen mit dem Stellteil bzw. Stellzylinder verbundenen Drehtisch gemeinsam verstellbar sind.

Von besonderer Bedeutung ist für die vorliegende Erfindung, daß der erste Substrathalter bzw. Deckel über eine Hubvorrichtung verstellbar ist, der zu einem am Greiferarm angeschlossenen und zu in einem die Feder aufnehmenden Zylinder geführten Kolben gehört, der mit dem Deckel bzw. Substrathalter verbunden ist. Durch die Ausnutzung des Differenzdrucks der den Teller des ersten Greiferarms in der unteren Stellung so lange festhält, bis die Schleuse geflutet werden kann, wird auf ein zusätzliches Antriebsmittel bzw. einen Einstellzylinder verzichtet.

Im Zusammenhang mit der erfindungsgemäßen Ausbildung und Anordnung ist es von Vorteil, daß der Substrathalter bzw. Deckel über mindestens zwei Hubvorrichtungen verstellbar ist, die den Substrathalter bzw. Deckel in Richtung des Greiferarms ziehen, und der Substrathalter bzw. Deckel mindestens einen Sensor zur Detektierung des Substrats aufweist.

Weitere Vorteile ergeben sich aus den Unteransprüchen.

**Weitere Vorteile und Einzelheiten der Erfindung sind in den Patentansprüchen** und in der Beschreibung erläutert und in den Figuren dargestellt, wobei bemerkt wird, daß alle Einzelmerkmale und alle Kombinationen von Einzelmerkmalen erfindungswesentlich sind. Es zeigt:

Figur 1    eine schematische Darstellung einer CD-Produktionsanlage in Draufsicht,

Figur 2a    eine Schnittdarstellung eines Substratgreifers oder eines Greiferarms einer in der Zeichnung der Einfachheit halber nicht dargestellten Sputteranlage zur Beförderung von Substraten bzw. Compact Disks, wobei am unteren Teil des Tragarms ein gegen die Stellkraft einer Feder verstellbares Greiferelement angeordnet ist,

Figur 2b    eine Teilansicht des im Greiferarm verstellbar gelagerten Substrathalters.

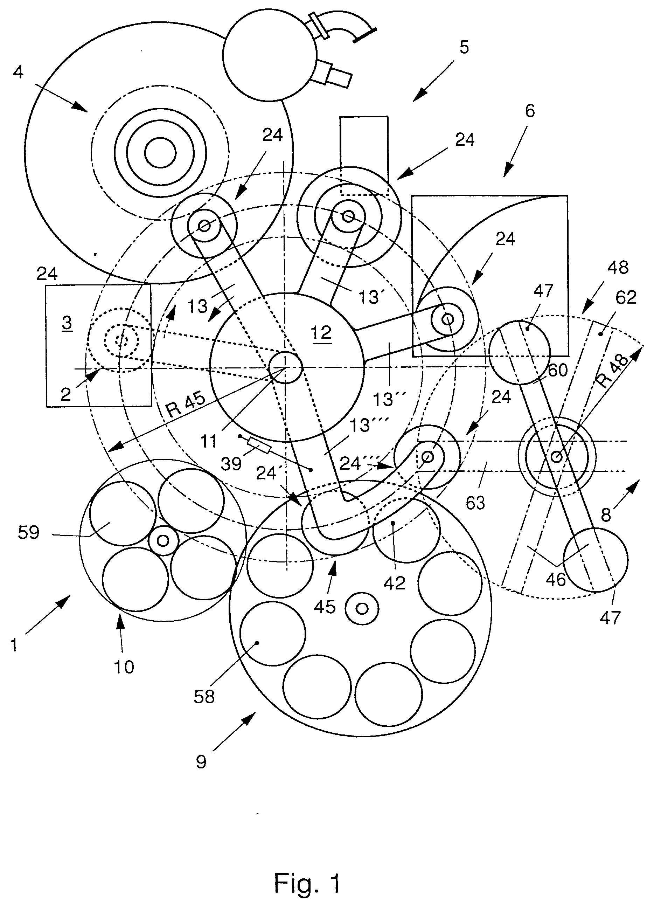

Wie aus Figur 1 hervorgeht, werden über eine Vorrichtung 1 zum Greifen und Halten und/oder Transportieren von Substraten 2 die Substrate mittels Greiferarmen 13 weiterbewegt. Die Substrate 2 werden im Bereich der Eingangsstation bzw. Übergabestation 3 von dem entgegengesetzt zum Uhrzeigerdrehsinn verstellten Substratgreifer oder Greiferarm 13 aufgenommen und dann mit diesem im Uhrzeigerdrehsinn zu einer ersten Prozeßstation bzw. Vakuumbeschichtungseinrichtung 4, zu der eine in der Zeichnung nicht dargestellte Kathode gehört, weitergeleitet. Der Greiferarm 13 ist wie die übrigen Greiferarme 13', 13" auf einem Drehtisch 12 fest angeordnet. Die Greiferarme 13, 13,' 13'" weisen je einen Substratgreifer 24, 24' auf. Der Greiferarm 13'" ist mit zwei Greifern 24' versehen.

Der mit dem Drehtisch 12 fest verbundene zweite Greiferarm 13' kann nach Verstellen des Drehtisches 12 entgegengesetzt zum Uhrzeigerdrehsinn das beschichtete Substrat 2 mittels des Substratgreifers 24 an der Prozeßstation 4 aufnehmen und durch eine weitere Bewegung des Drehtisches 12 im Uhrzeigerdrehsinn der Prozeßstation 5 zuführen, in der das Substrat 2 mit Lack beschichtet wird. Von der Prozeßstation 5 wird durch den Greiferarm 13", der hierzu ebenfalls entgegengesetzt zum Uhrzeigerdrehsinn verschwenkt wird, das beschichtete bzw. lackierte Substrat 2 aufgenommen und dann einer Prozeßstation 6, und zwar der Lacktrocknungseinrichtung, zugeführt. Hierzu verschwenkt der Greiferarm 13" zuerst in die Position 5, nimmt das Substrat 2 auf und verschwenkt dann wieder in die Position 6, von der aus das Substrat 2 zur Lacktrocknungseinrichtung 6 gelangt. Von der Prozeßstation 6 (Lacktrocknung) gelangt das Substrat 2 über den Greiferarm 13'" zu einer Kontroll- bzw. Scan-Position 7. Hierzu wird ein L-förmig ausgebildeter Greiferarm 13'" mittels des Drehtisches 12 entgegengesetzt zum Uhrzeigerdrehsinn verschwenkt, so daß der Substratgreifer 24 das Substrat 2 an der Position 6 aufnehmen und dann zur Kontroll- bzw. Scan-Position 7 verschwenken kann.

Die Position 7 stellt, wie bereits erwähnt, eine Kontrollstation oder Doppelinspektionseinrichtung dar, der eine Druckstation 8 zugeordnet ist.

Mit der Doppelinspektionseinrichtung 7 kann das Substrat 2 auf der Ober- und Unterseite gescannt werden und auf diese Weise die Lack- und Druckqualität überwacht werden, d.h. es können alle Fehler, z.B. Kratzer, bei beim Drucken entstehen, ermittelt werden.

Es kann also festgestellt werden, ob eine einwandfreie Diskqualität vorliegt, wozu die CD auch von der Unterseite gescannt werden kann. Das Besondere an dieser Inspektion ist, daß die CD, die vorher schon einmal gescannt worden war, jetzt nach dem Druckvorgang nochmals auf nachträgliche Fehler geprüft wird, die beim Druckvorgang entstanden sind. Es lassen sich also dadurch auch schnelle Rückschlüsse auf das einwandfreie Arbeiten des Druckers ziehen.

Nach der Doppelinspektion an der Prozeßstation 7 wird das Substrat 2 über den L-förmigen Greiferarm 13'" einer ersten Abgabestation 9 für einwandfreie CDs oder einer zweiten Abgabestation 10 für aussortierte, also mindere Qualität aufweisende CDs weitergeleitet.

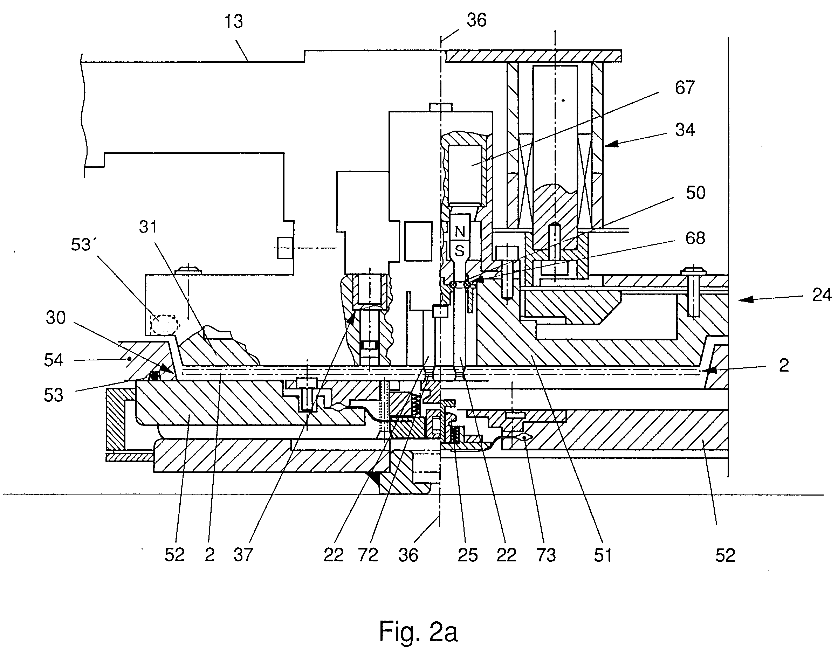

In Figur 2a ist ein besonders ausgestalteter erster Greiferarm 13 dargestellt, der ebenfalls über den Drehtisch 12 im Uhrzeigerdrehsinn oder entgegengesetzt dazu zwischen den beiden Prozeßstationen 3 und 4 verstellt werden kann. Neben der Horizontalverstellung des Greiferarms 13 besteht ferner die Möglichkeit, daß der Substratgreifer 24 mit den zugehörigen Greiferelementen 22 unabhängig von der Hubbewegung des Drehtisches 12 verstellt werden kann. Hierzu dient ein in der Zeichnung nicht dargestelltes Kurvengetriebe.

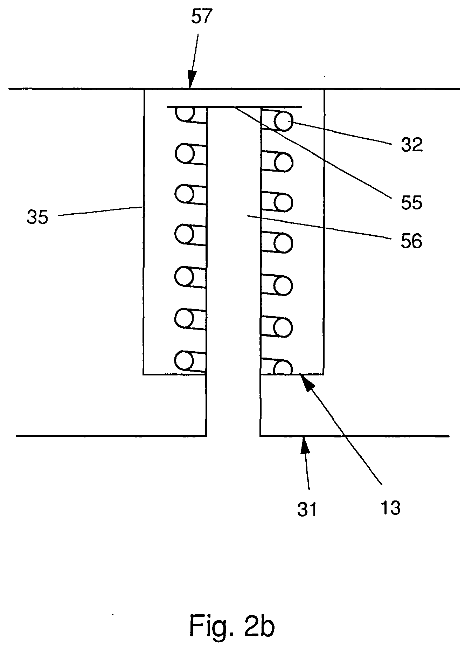

Der in Figur 2a dargestellte Greiferarm 13 ist eine Zuführeinrichtung einer in der Zeichnung nicht dargestellten Sputteranlage, zu der der Greiferarm 13 gehört, mit dem die in Figur 2 mit 2 bezeichneten Substrate bzw. Compact Disks (CD) einem Substrathalter 52 (Fig. 2a) zugeführt werden. Über diese Vorrichtung 1 gelangen die Substrate zu der Prozeßstation 4, in der diese beschichtet werden.

Der in Figur 2a dargestellte Greiferarm 13 weist hierzu mehrere um eine horizontal verlaufende Achse 50 schwenkbare Greifer 22 auf. Die Greifer 22 sind hierzu in einem zylinderförmigen Gehäuse 51 angeordnet, das zur Aufnahme eines Elektromagneten bzw. Ringmagneten 67 dient, der mit einer in der Zeichnung nicht dargestellten Stromversorgungseinrichtung verbindbar ist. Der Elektromagnet bzw. Ringmagnet 67 dient zum Verstellen der in elastischen Lagern 68 aufgenommenen Greifer 22, die hierzu zwischen zwei Anschlägen verschwenkbar sind. Im Ausführungsbeispiel ist der obere Magnet mit N und der untere mit S bezeichnet. Durch Einschalten des Ringmagneten 67 lassen sich die Greifer zwischen den beiden Anschlägen verstellen und legen dabei einen Weg zwischen der dargestellten Position und einer geneigt verlaufenden Stellung zurück. In der in Figur 2a dargestellten Halteposition verläuft die Längsachse der Greifer 22 parallel zu einer Längsmittelachse 36 des Substrathalters bzw. Deckels 31. In dieser Stellung wird das Substrat 2 über am unteren Ende der Greifer 22 vorgesehene, nutenförmige Vertiefungen 72 gesichert.

In Figur 2a sind lediglich zwei Greiferarme 22 sichtbar. Es ist jedoch vorteilhaft, beispielsweise drei Greifer um jeweils 120° versetzt zueinander auszurichten, so daß diese in entsprechende Zwischenräume von Substratgreifern 25 eines zweiten darunterliegenden Substrathalters 52 eingreifen können. Durch die vorteilhaft angeordneten Zwischenräume im unteren Substrathalter 52 können die beiden Vorrichtungen 24 und 52 sehr dicht aneinander herangeführt werden und somit eine exakte Übergabe der Substrate 2 zwischen den beiden Vorrichtungen sicherstellen, wobei bei der Übergabe der Substrate 2 die oberen Greifer 22 kurzfristig in die Zwischenräume der unteren Greifer 25 eingreifen, wenn die beiden Vorrichtungen zusammengefahren werden.

Einzelheiten des Zusammenwirkens der beiden Substrathalter 24 und 22 ergeben sich aus den am gleichen Tag eingereichten Anmeldungen DE 196 05 598.9 und DE 196 05 599.7, Seite 20 bis 21.

Wird beispielsweise das Substrat 2 über die obere Vorrichtung bzw. den Substratgreifer 13 an die in Figur 2 schematisch dargestellte, untere Vorrichtung bzw. den Substrathalter 52 herangefahren, so legt sich der Schleusendeckel mittels einer Dichtung 53 dichtend gegen die Stirnfläche eines Rezipientendeckels an. Dabei bildet sich zwischen der Oberfläche des Substrathalters 24 und der Unterseite eines Schleusendeckels 54 eine Schleusenkammer 30, die über in der Zeichnung nicht dargestellte Leitungen entweder geflutet oder evakuiert werden kann, wenn das für den Prozeßablauf erforderlich ist. Der Schleusendeckel 54 ist ferner über eine Dichtung 53 gegenüber dem Deckel 52 abgedichtet.

Die Übergabe des Substrats 2 von der oberen Vorrichtung bzw. den Greiferarmen 13 zu der unteren Vorrichtung bzw. den Substratgreifern 25 geschieht in folgenden Arbeitsschritten:

Zuerst wird ein in der Zeichnung nicht dargestelltes Ventil geöffnet und die Schleusenkammer 30 über eine nicht dargestellte Pumpe evakuiert. Hierdurch entsteht Druckgleichheit auf der Ober- und Unterseite des Substrathalters 52. In diesem Stadium nimmt eine Membrane 73 eine Stellung ein, in der die Substratgreifer 25 nach außen geschwenkt sind und dabei das den Greifern 22 zugeführte Substrat 2 halten. Hierzu wird zum gleichen Zeitpunkt der Ringmagnet 67 angesteuert und verschwenkt die Greifer 22 in eine geneigt verlaufende Position, wobei die oberen Enden der Greifer 22 gegen entsprechende Anschläge zur Anlage kommen und dabei das Substrat 2 freigeben. Nun kann der Substrathalter 52 in die in Figur 2a dargestellte rechte, untere Stellung verschoben werden, wobei gleichzeitig der Teller bzw. Substrathalter über die Membrane bzw. die Verbindungselemente nach unten geführt wird, bis der Substrathalter gegen einen Anschlag des Drehtellers anliegt. Nun kann der Substrathalter 52 mit dem Substrat eine Schwenkbewegung ausführen, ohne daß eine Relativbewegung zwischen Substrathalter und Drehteller auftritt.

Nach diesem Arbeitsablauf nimmt der nächste, in der Zeichnung nicht dargestellte Substrathalter die zuvor beschriebene Position ein, wozu der Substrathalter 52 wieder nach oben gefahren wird, bis er gegen eine Dichtung 54 anliegt und die Einschleuskammer 30 verschließt. Bei diesem Steilvorgang bleibt das Substrat 2 so lange in den Greifern 25, bis ein entsprechendes, in der Zeichnung nicht dargestelltes Ventil geöffnet und die Schleusenkammer geflutet wird, so daß in der Einschleuskammer ein Atmosphärendruck eintritt. Hierdurch entsteht der erforderliche Differenzdruck $P_d$ zwischen der Ober- und Unterseite des Substrathalters 52, und die zugehörigen Membrane 73 bewegen sich weiter in den Vakuumraum, wobei die zugehörigen Greifer 25 in eine geneigt verlaufende Position verschwenken. Hierdurch wird das Substrat 2 freigegeben. Nun können zum gleichen Zeitpunkt auch die Greifer 22 der oberen Vorrichtung angesteuert werden, so daß sie aus ihrer geneigt verlaufenden Lage in eine vertikal verlaufende Lage verschwenkt werden und dabei das Substrat 2 erfassen. Jetzt kann das Substrat 2 abgehoben und durch Verschwenken des Greiferträgers das nächste Substrat in die beschriebene Position gebracht werden.

Im Ausführungsbeispiel gemäß Figur 2a sind die Greiferelemente 24 mittels des Drehtisches 12 gemeinsam in horizontaler und vertikaler Richtung (Siehe Hubvorrichtung gemäß Fig.2b) unabhängig von den übrigen Greiferarmen 13' bis 13''' verstellbar.

Die horizontal verlaufende Bewegungsebene bzw. Bewegungsrichtung der Greiferarme 13 verläuft parallel zur Bewegungsebene oder Oberfläche des Drehtisches 12 oder der Standfläche der Vorrichtung 1 und schneidet dabei eine Drehachse 11 des Drehtisches 12 in einem annähernd rechten Winkel. Das Verstellen des Greiferelements 24 in Richtung der Mittelachse 36 erfolgt über eine in Figur 2a schematisch dargestellte Hubvorrichtung 34, die aus einem an den Greiferarm 13 angeschlossenen, hohlförmigen Zylinder 35 und einer im Zylinder aufgenommenen Feder 32 besteht, die mit ihrem oberen Ende gegen einen Anschlag 55 und mit ihrem unteren Ende gegen den Greiferarm 13 zur Anlage kommt. In dem Zylinder 35 ist ein Kolben 56 geführt, der mit seinem unteren Ende mit dem Deckel 31 des Substratgreifers 13 fest verbunden ist. Das obere Ende des Kolbens 56 weist ebenfalls einen Anschlag 57 auf.

Soll beispielsweise der Drehtisch 12 gemeinsam mit allen Greifarmen 13 bis 13''' angehoben werden, so kann der Substrathalter 31 des Greiferarms 13 in der in Figur 2 dargestellten Position verharren, damit der notwendige Vakuumdruck in der Schleusenkammer 30 gehalten wird, wenn der untere Substrathalter 52 das Substrat 2 zur Prozeßstation 4 weiterleitet (Figur 1). Es wird also mittels der Hubvorrichtung 34 eine Entkopplung des Substrathalters 31 von dem übrigen Teil des Greiferarms 13 erreicht, wenn dieser nach oben verstellt werden muß und der Substrathalter 31 in der die Schleusenkammer 30 verschließenden Stellung verharren soll.

Bei einer Hubbewegung des Greiferarms 13 bleibt der Substrathalter 31 mit dem Greiferelement 24 in seiner unteren Stellung und wird dabei über den sich in der Schleusenkammer 30 aufbauenden Differenzdruck Pd gehalten. Der Differenzdruck Pd wirkt auf den Substrathalter bzw. Deckel 31 und drückt diesen auf den Rezipienten- oder Kammerdeckel, so daß das vom Drehteller aufgenommene Substrat 2 an eine Kathode weitergeleitet werden kann.

Wird jedoch die Schleusenkammer 30 geflutet, so kann der Substrathalter bzw. Deckel 31 über eine oder mehrere Hubvorrichtungen verstellt werden, wobei die Feder 32 den im Zylinder 35 vorgesehenen Kolben 56 automatisch nach oben fährt, so daß der Deckel 31 gegen einen oberen Anschlag des Greiferarms 13 zur Anlage kommt und somit die Greifer der Greiferarme 13 bis 13''' sich in einer angehobenen Stellung befinden und der Drehtisch 12 die einzelnen Greiferarme 13 bis 13''' in die gewünschte nächste Prozeßstation drehen kann, wobei dann die erneute Substratübergabe, wie bereits beschrieben, erfolgen kann.

Beim nachfolgenden Arbeitsvorgang beziehungsweise der Substratübergabe wird wiederum der Deckel 31 an den Substrathalter 52 herangeführt und bei entsprechender Evakuierung der Schleusenkammer 30 der Substrathalter in der unteren Position gehalten. Bei erneutem Verstellen des Greiferarms 13 nach oben wird der Deckel 31 nicht mitgeführt, so daß die Feder 32 über den Tragarm 13 zusammengedrückt wird. Die somit gespeicherte Stellkraft in der Feder 32 reicht aus, um den Deckel 31 nach oben zu fahren, wenn nach abgeschlossenem Arbeitsvorgang die Schleusenkammer 30 wieder geflutet wird.

Durch die vorteilhafte Ausbildung wird erreicht, daß der der Kathode zugeordnete Greiferarm 13 mittels der Hubvorrichtung unabhängig von den übrigen Greiferarmen verstellbar ist. Wird also, wie bereits erwähnt, in der ersten Stellung bzw. in der Übergabeposition des Substrats zwischen Greiferelement 13 und der Schleusenkammer 30 der Beschichtungsanlage das Substrat in die Schleuse eingegeben, so kann der im Greiferarm angeordnete Deckel 31 vakuumdicht auf der Schleusenkammer verbleiben, und durch die Entkopplung des Tellers vom Greiferarm kann der Greiferarm 13 alleine nach oben verstellt werden, wobei der in der Schleuse auftretende Differenzdruck Pd = Pa - Pv den Teller auf der Schleusenkammer 30 hält.

Durch den Anhubvorgang werden auch die übrigen fest mit den Greiferarmen 13' bis 13''' verbundenen Teller bzw. die zugehörigen Greiferelemente 24 an den einzelnen Arbeitspositionen nach oben verstellt, so daß diese mittels des Drehtisches 12 weitergedreht und dadurch in ihre neue Arbeitsposition verstellt werden können.

Bei diesem Arbeitsvorgang wird der Substrataustausch an den einzelnen Prozeßpositionen nicht beeinträchtigt. Wird die Schleusenkammer 30 des ersten Substratgreifers 13 wieder geflutet, kann der Teller 31 mittels der Feder 32 der Hubvorrichtung nach oben schnellen, so daß der Greiferarm 13 wieder in seine Aus- oder Eingangsposition 3 zurückverstellt wird.

In einem weiteren Ausführungsbeispiel gemäß Figur 1 ist eine Doppelinspektions-Einrichtung dargestellt, die sich an der Prozeßstation 7 befindet. Der im Bereich der Prozeßstation 7 dargestellte, L-förmig ausgebildete Greiferarm 13''' ist einenends mit dem Drehtisch 12 verbunden und mit Bezug auf die Drehachse 11 des Drehtisches 12 in vertikaler Richtung oder in Richtung der Hubbewegung des Drehtisches 12 verstellbar, wenn hierzu der Drehtisch 12 nach oben bzw. nach unten gefahren wird. Der Greiferarm 13''' weist an seinem äußeren bzw. freien Ende einen in etwa rechtwinklig angeordneten Tragarm 42 auf, der auf einem Kreisbogen liegt, wobei der Radiusdurchmesser 45 dieses Kreisbogens in etwa dem Radiusdurchmesser der Bewegungsbahn des äußeren Endes des Tragarms 42 entspricht bzw. der Bewegungsbahn der Achsen der Substrathalter 24.

Wie bereits erwähnt, kann der L-förmige Tragarm 13''' gemeinsam mit dem Drehtisch 12 verstellt werden. Ferner ist es jedoch auch möglich, daß der Tragarm 13''' über eine entsprechende Stellvorrichtung bzw. eine Exzenterantriebsvorrichtung 39 zwischen der in Figur 1 dargestellten ersten Ausgabestation 9 und der zweiten Ausgabestation 10 verstellt werden kann. Hierzu ist der Exzenterantrieb 39, zu dem ein Hydraulikzylinder gehören kann, einenends mit dem Tragarm 42 und anderenends mit dem Drehtisch 12 verbunden. Auf diese Weise kann der Substratgreifer 13''' aus der in Figur 1 dargestellten Position verstellt werden, in der die Substrate aus der Kontrollstation 7 übernommen und nach entsprechender Schwenkbewegung des Substratgreifers 13''' in die Position 9, d.h. in die erste Ausgabestation, verschwenkt werden, um die als einwandfrei detektierten Substrate 2 auf dem Drehteller 58 abzulegen. Mittels des Exzenterantriebs 39 kann der L-förmige Substratgreifer 13''' auch in die Position 10 bzw. in die zweite Ausgabestation verschwenkt werden, wobei Substrate 24' auf einem Drehteller 59 abgelegt werden.

Der gebogene Tragarm 42 ist gemäß Figur 1 so angeordnet, daß er die Tragsäule der Scan-Vorrichtung zur Detektierung der Lackschicht oder des Farbaufdrucks, die mit der Position 7 angegeben ist, umfahren bzw. umgreifen kann, so daß eine Kollision zwischen diesen beiden Vorrichtungsteilen 7 und 42 vermieden wird. Wird beispielsweise über den Greiferarm 13'''' und den zugehörigen Substratgreifer 24 das Substrat aus der Prozeßstation (Lacktrocknung) 6 in die Kontrolleinrichtung oder Scan-Position 7 verstellt, so besteht die erste Möglichkeit, mittels der in der Zeichnung lediglich schematisch angedeuteten Scan-Einrichtung 7 den Lack auf Fehler zu untersuchen.

Alle im vorherigen Scan-Prozeß als nicht einwandfrei gescannten Substrate 2 können bereits in dieser Position über den Greifer 13''' mittels des Substratgreifers 24' aufgenommen und der zweiten Abgabeposition 10 zugeführt werden.

Der L-förmige Greiferarm 13 kann zwischen der Prozeßstation 7 und der Prozeßstation 9 bzw. 10 verstellt werden. Hierzu weist der Tragarm 42 in vorteilhafter Weise an seinem äußeren Ende den ersten Substratgreifer 24 und am inneren Ende bzw. an der Winkelstelle des Greiferarms 13''' den zweiten Substratgreifer 24' auf. Mittels des Substratgreifers 24 werden die Substrate 2 dem Substratteller 58 und mittels des Substratgreifers 24' dem Aufnahmeteller 59 aufgegeben.

Die in der Station 7 als einwandfrei detektierten CDs können über einen doppelarmigen Greiferarm 46 erfaßt werden, der in eine erste Ruhestellung 60 und eine zweite Ruhestellung 62 sowie in eine Arbeitsstellung 63 verschwenkbar ist.

Das äußere Ende der Greiferarme 13 bis 13''' mit den Substratgreifern 24 bewegt sich auf dem Kreisradius 45 (R45), und das äußere Ende des Doppelgreiferarms 46 bewegt sich auf einem Kreisradius 48. Wie aus Figur 1 hervorgeht, überschneiden sich die beiden Kreisradien 45 und 48, so daß in der inaktiven Stellung bzw. in der Ruhestellung 60 und 62 des Doppelgreiferarms 46 diese außerhalb des Kreisradius 45 bewegt werden müssen, damit sie nicht mit dem Greiferarm 13''' bzw. dessen Substratgreifern 24, 24' kollidieren. Ferner ist es wichtig, daß bei einer Verstellung des Doppelgreiferarms 46 in die Position 63 der L-förmige Arm auch im Uhrzeigerdrehsinn weggeschwenkt sein kann, so daß der Arm 46 in die gestrichelte Position verschwenkt werden kann. Befindet sich der Doppelgreiferarm 46 in seiner Zwischenstellung, dann kann der L-förmige Arm verstellt werden. Der L-förmige Arm 13''' muß auch deshalb im Uhrzeigerdrehsinn verstellt werden, damit für das Lackprüfgerät die Sicht von oben auf die zu prüfende CD freigegeben ist. Der Doppelgreiferarm 46 kann also von der in ausgezogenen Linien dargestellten ersten Ruhestellung 60 in eine Substratübergabestellung oder Arbeitsstellung 63 verstellt werden und legt dabei einen Winkel von ca. 60° zurück. In der Arbeitsstellung 63 ergreift der Substratgreifer 47 des Doppelgreiferarms 46 das Substrat 2 in der Prozeßstation 7 und führt das dort bereits auf Lackfehler und Diskqualität detektierte einwandfreie Substrat 2 von der Prozeßstation 7 nach einer Verschwenkung des Doppelgreiferarms 46 um 180° zur Prozeßstation 8, in der sich auch die Druckeinrichtung oder Farbgebungseinrichtung befindet. Bei der Schwenkbewegung aus der ersten Ruhestellung 60 in die Arbeitsstellung 63 und dann um 180° im Uhrzeigerdrehsinn in die Übergabestellung wird das von der Prozeßstation 7 aufgenommene Substrat 2 der Druckstation oder Farbgebungsstation 8 übergeben und gleichzeitig ein bereits bedrucktes Substrat 2 über das andere Ende dem Greiferarm 46 zugeführt und dort abgegeben. Nach diesem Schwenkvorgang wird der Doppelgreiferarm 46 in die zweite Ruhestellung 62 (gestrichelte Darstellung) gebracht.

Nach dem Substrataustausch kann das nun bedruckte Substrat auf der zweiten Seite detektiert werden, wobei festgestellt wird, ob eine einwandfreie Diskqualität vorliegt. Die Prüfung erfolgt also auch auf der Unterseite der CD und ermittelt beim Drucken eventuell entstandene Kratzer.

Bei der zweiten Übergabe des Substrats 2 zwischen der Prozeßstation 7 und der Prozeßstation 8 erfolgt der Substrataustausch durch den umgekehrten Ablauf der Schwenkbewegung des Greiferarms 46. Nun wird der Greiferarm aus der gestrichelten Ruhestellung 62 im Uhrzeigerdrehsinn in die Arbeitsstellung 63 verschwenkt und nimmt dort das Substrat 2 an der Prozeßstation 7 auf und der andere Greiferarm das bedruckte Substrat an der Prozeßstation 8. Nun dreht sich der Substratgreifer im entgegengesetzten Uhrzeigerdrehsinn um 180° und nimmt dabei, wie bereits erwähnt, den Substrataustausch vor. Auf diese Weise kann ein bereits bedrucktes Substrat gescannt und ein noch nicht bedrucktes Substrat mit einem Aufdruck versehen werden.

Durch diese Doppelinspektions-Einrichtung, die in vorteilhafter Weise an der Peripherie des Drehtisches 12 angeordnet ist, läßt sich der Prozeßablauf verkürzen und eine einwandfreie Übergabe der Substrate 2 zwischen den beiden Positionen 7 und 8 vornehmen, und gleichzeitig können die Substrate über den Substratgreifer 13''' entweder zur Abgabestation 9 oder 10 weitergeführt werden.

Der Exzenterantrieb 39 ist ebenfalls auf dem Drehtisch 12 angeordnet und dient, wie bereits erwähnt, zum Verstellen des Substratgreifers 13''' zwischen der Prozeßstation 9 bzw. 10 und der Scan-Position 7.

Durch die vorteilhafte Vorrichtung gemäß Figur 1 kann, wie eingangs bereits dargestellt, durch ein in der Zeichnung nicht dargestelltes Getriebe bzw. Kurvenscheibengetriebe in Verbindung mit einem Schrittmotor eine Dreh- und eine Hubbewegung für den Drehtisch ausgeführt werden, so daß auf die bisher üblichen Hubzylinder für die einzelnen Greiferarme 13 bis 13''' verzichtet werden kann. Durch die Entkopplung des Substratgreifers 24 von dem ersten Greiferarm 13 läßt sich eine Hubbewegung aller Greiferarme über eine einzige Stellvorrichtung, nämlich mittels des Drehtisches 12, vornehmen, so daß der Substrataustausch an den einzelnen Prozeßstationen störungsfrei durchgeführt werden kann. Insgesamt kann man bei dieser Vorrichtung mit lediglich vier bzw. fünf Substratgreifern auskommen, so daß die Vorrichtung hierdurch preiswerter wird. Im Ausführungsbeispiel gemäß Figur 1 ist der Drehtisch 12 mit lediglich vier Substratgreiferarmen ausgestattet, wobei drei aus einem gerade verlaufenden und der vierte aus einem L-förmigen Teil bestehen. Mit diese~ Greiferarmen 13 bis 13''' lassen sich insgesamt sieben verschiedene Positionen (Eingangsposition 3, Beschichtungsposition 4, Lackierungsposition 5, Trocknungsposition 6, Scan-Position 7 und zwei Ablagepositionen 9, 10) erreichen. Hierdurch wird die Zykluszeit insgesamt sowie die Anzahl der Verstellelemente auf ein Minimum reduziert.

Die Greifer 22 können als Saugelemente ausgebildet sein oder mittels ihre endseitigen Einkerbung das Substrat 2 in der Mittelbohrung oder am Außenrand erfassen.

Bezugszeichenliste

| | |
|---|---|
| 1 | Transportvorrichtung zur Beförderung von Substraten |
| 2 | Substrat = Compact Disk (CD) |
| 3 | Ausgangsstation = Übergabestation = Aufnahmestation Eingabe des Substrats |
| 4 | Prozeßstation, Bearbeitungsvorrichtung= Vakuumbeschichtungseinrichtung |
| 5 | Prozeßstation, Lackauftragung |
| 6 | Prozeßstation, Lacktrocknung (UV) |
| 7 | Prozeßstation, Qualitätsprüfer, Scanner |
| 8 | Prozeßstation, Druckeinrichtung, Satellitenstation |
| 9 | Prozeßstation, Kontrollstation |
| 10 | 2. Ausgabestation, Sammeln des Substrats 2, Aufnahmestation |
| 11 | Drehachse |
| 12 | Drehtisch |
| 13 | Substratgreifer, ein- oder mehrarmiger Greiferarm |
| 13' | Substratgreifer, ein- oder mehrarmiger Greiferarm |
| 13'' | Substratgreifer, ein- oder mehrarmiger Greiferarm |
| 13''' | Substratgreifer, ein- oder mehrarmiger Greiferarm |
| 14 | Ablagestation für CD mit guter Qualität |
| 15 | Aufnahmestation |
| 16 | Gehäuse |
| 17 | Hauptteil |
| 18 | Hauptteil |
| 19 | Tragarm |
| 20 | Tragarm |
| 21 | Achse |
| 22 | Greiferelement, Greifer |
| 23 | Greiferelement |
| 24 | Substratgreifer = Greifelement |
| 24' | Substratgreifer (schlechte Qualität) |
| 25 | Substratgreifer |
| 26 | Substratgreifer |
| 27 | Drehteller |
| 28 | Stift |
| 29 | Ablagestation für CD mit schlechter Qualität |
| 31 | erster Deckel, Substrathalter |
| 30 | Schleusenkammer |
| 32 | Feder |
| 34 | Hubvorrichtung |
| 35 | Zylinder |
| 36 | Mittelachse v. Substrathalter bzw. Deckel (31) |
| 37 | Sensor zur Detektierung des Substrats (2) |
| 39 | Stellvorrichtung, Hubzylinder, Exzenterantrieb |
| 40 | Entladestation |
| 41 | Entladestation |
| 42 | Tragarm |
| 43 | Scan-Position |
| 44 | Druckerposition |
| 45 | Greifer-Bewegungsbahn/Kreisradius von Teller 31 |
| 46 | doppelarmiger Greiferarm |
| 47 | Substratgreifer des doppelarmigen Greiferarms |
| 48 | Kreisradius des doppelarmige Greiferarms (R 48) |
| 50 | Achse für Greifer 22 |
| 51 | Gehäuse für Greifer 22 |
| 52 | Substrathalter/Rezipientendeckel |
| 53 | Dichtung |
| 53' | Schleusendeckel |
| 55 | Anschlag Feder 32 |
| 56 | Kolben |
| 57 | Anschlag Kolben 56 |
| 58 | Aufnahmeteller |
| 59 | Aufnahmeteller |
| 60 | 1. Ruhestellung Greiferarm 46 |
| 61 | 2. Ruhestellung Greiferarm 46 |
| 63 | Arbeitsstellung |
| 67 | Elektromagnet, Ringmagnet |
| 68 | elastisches Lager |
| 72 | Vertiefung (Greifer), Nut |
| 73 | Membrane |
| 75 | Vakuumraum |

**Patentansprüche**

1. Vorrichtung (1) zum Greifen, Halten und/oder Transportieren von Substraten (2), zu der eine Eingangsstation (3) und mehrere in Reihe oder kreisförmig angeordnete Prozeßstationen (4 bis 9) zur Aufnahme des Substrats (2) gehören, zu denen das Substrat (2) über eine an Greiferarmen (13) angeordnete, Greiferelemente (24) aufweisende Transportvorrichtung (1) bzw. einen Drehtisch (12) weitergeleitet und dann an eine oder mehrere Ablagestationen (14) abgegeben wird, wobei mehrere Greiferarme (13) mittels des Drehtisches (12) in horizontaler und/oder vertikaler Richtung verstellbar sind, **dadurch gekennzeichnet**, daß einige an den Greiferarmen (13) angeordnete Greiferelemente (24) mittels des Drehtischs (12) gemeinsam in horizontaler und/oder vertikaler Richtung und zumindest ein Greiferelement (24) von der Bewegung des Greiferarmes (13) abkoppelbar ist, bzw. daß einige Greiferelemente (24) mittels des Drehtischs (12) gemeinsam in horizontaler und/oder vertikaler Richtung verstellbar sind und zumindest ein Greiferarm (13') unabhängig von den übrigen Greiferarmen (13) in mindestens eine der Bewegungsrichtungen verstellbar ist.

2. Vorrichtung nach Anspruch 1, **dadurch gekennzeichnet**, daß das eine bzw. erste Greiferelement (24) zumindest achsparallel zur Mittelachse (36) des Drehtisches (12) unabhängig von den übrigen Greiferarmen (13) bzw. Greiferelementen (24) verstellbar ist, oder daß das eine bzw. erste Greiferelement (24) zumindest in eine vertikale Bewegungsrichtung unabhängig von den übrigen Greiferarmen (13) bzw. Greiferelementen (24) verstellbar ist.

3. Vorrichtung nach Anspruch 1 oder 2, **dadurch gekennzeichnet**, daß ein Greiferelement (24) zumindest in eine horizontale Bewegungsrichtung unabhängig von den anderen Greiferelementen (24) und/oder Greiferarmen (13) verstellbar ist, deren Bewegungsebene oder Bewegungsrichtung in etwa parallel zur Bewegungsebene oder Oberfläche des Drehtisches (12) oder der Standfläche der Vorrichtung (1) verläuft oder die Drehachse (11) des Drehtisches (12) in einem annähernd rechten Winkel schneidet.

4. Vorrichtung nach Anspruch 1, **dadurch gekennzeichnet**, daß das eine bzw. erste Greiferelement (24) zumindest in Richtung der Hubbewegung des Greiferarms (13) unabhängig von der Hubbewegung des Greiferarms (13) verstellbar ist.

5. Vorrichtung nach einem oder mehreren der vorhergehenden Ansprüche, **dadurch gekennzeichnet**, daß bei einer Hubbewegung des Greiferarms (13) das Greiferelement (24) mit dem zugehörigen Deckel (31) über einen sich in einer Schleusenkammer (30) aufbauenden Differenzdruck $P_d$ auf dem im Substrathalter (31) liegenden Kammer- oder Rezipientendeckel gehalten und das vom Drehteller aufgenommene Substrat (2) an eine Kathode weitergeleitet wird.

6. Vorrichtung nach Anspruch 1, **dadurch gekennzeichnet**, daß der Substrathalter bzw. Deckel (31) in einer Richtung über den Differenzdruck $P_a$ gehalten wird und in der anderen Richtung über die Stellkraft eines Druckmittels bzw. einer Feder (32) verstellbar ist und die anderen Substrathalter bzw. Deckel (31) in mindestens einer Richtung über einen mit dem Stellteil bzw. Stellzylinder verbundenen Drehtisch (12) gemeinsam verstellbar sind.

7. Vorrichtung nach einem oder mehreren der vorhergehenden Ansprüche, **dadurch gekennzeichnet**, daß der erste Substrathalter bzw. Deckel (31) über eine Hubvorrichtung (34) verstellbar ist, der zu einem am Greiferarm (13) angeschlossenen und zu in einem die Feder (32) aufnehmenden Zylinder (35) geführten Kolben (56) gehört, der mit dem Deckel bzw. Substrathalter (31) verbunden ist.

8. Vorrichtung nach einem oder mehreren der vorhergehenden Ansprüche, **dadurch gekennzeichnet**, daß der Substrathalter bzw. Deckel (31) über mindestens eine oder mehrere Hubvorrichtungen (34) verstellbar ist, die den Substrathalter bzw. Deckel (31) in Richtung des Greiferarms (13) ziehen.

9. Vorrichtung nach einem oder mehreren der vorhergehenden Ansprüche, **dadurch gekennzeichnet**, daß der Substrathalter bzw. Deckel (31) mindestens einen Sensor (37) zur Detektierung des Substrats (2) aufweist.

Fig. 1

Fig. 2a

Fig. 2b